# EUROPEAN PATENT APPLICATION

(11) **EP 4 516 736 A1**
(43) Date of publication of application: **05.03.2025**
(21) Application number: 23194831.6
(22) Date of filing: 01.09.2023
(51) Int. Cl.: C01B 32/186, C23C 16/01, C23C 16/02, C23C 16/26

(54) **LAYERED STRUCTURE AND METHOD FOR THE PRODUCTION OF GRAPHENE**

(71) Applicant: Black Semiconductor GmbH, 52072 Aachen (DE)
(72) Inventor: Wagner, Stefan, 52072 Aachen (DE); Huyghebaert, Cedric, 52072 Aachen (DE); Winter, Zachary, 52072 Aachen (DE)
(74) Representative: Herzog IP Patentanwalts GmbH

(57) **Abstract**

The invention pertains to a layered structure (100) comprising
a. A first layer (101), wherein
i. the first layer (101) comprises a first metal and at least one other chemical element, wherein the at least one other chemical element is preferably at least one further metal,
ii. the first layer (101) has a first section (112), wherein the first section (112) has a crystal orientation that lies in a first crystal plane;
iii. the Miller index ℓ, used to define the crystal lattice planes, is arranged perpendicular to a surface (108) of the first layer (101);
wherein
a first angle (111) between the first crystal plane and the (168)-plane is in the range of -18° to 18°, preferably in the range of -12° to 12°, more preferably in the range of -8° to 8°, further preferably in the range of -5° to 5°, and even further preferably in the range of -4° to 4.

## Description

### FIELD OF THE INVENTION

The invention pertains to a layered structure, which can be used in a method for producing a graphene layer *e.g.,* by growing the graphene layer on the layered structure. The invention also pertains to a method for producing a graphene layer. The invention further pertains to a graphene layer obtainable by the method for producing a graphene layer.

### BACKGROUND

Graphene is material with a large number of highly desirable properties. Some of these properties include the following: is it a light-weight material with a tensile strength stronger than that of iron, and it is an excellent conductor of heat and electricity. As a result of having such desirable properties, graphene can be used for a large number of applications, including in the energy industry (*e.g.,* for a batteries), the medical industry (*e.g.,* cancer treatment), and the electronics industry (*e.g.,* in opto-electronic devices). Applications that use graphene generally require graphene of a sufficiently high quality. In particular, it is required that the graphene has very little wrinkles or folds. However, production of such high-quality graphene remains challenging. A method for producing graphene is described in, *e.g.,* US8,470,400, Wang et al. (2021), Nature, 596, 519, and Burton et al. (2023), ACS Nano, 17, 2, 1229.

### OBJECTS

An object of the present invention is to at least partially overcome at least one of the disadvantages encountered in the state of the art.

It is a further object of the invention to provide a layered structure that can be used to obtain (*e.g.,* produce) a graphene layer on said layered structure.

It is a further object of the invention to provide a layered structure that allows for a reduced adhesions force between the layered structure and a graphene layer superimposed on the layered structure.

It is a further object of the invention to provide a layered structure that allows for an improved delamination of a graphene layer superimposed on said layered structure. For example, the delamination is improved when the damage to the graphene layer, as a result of the delamination, is reduced.

It is a further object of the invention to provide a layered structure that can be reused for the obtaining of a graphene layer on said layered structure. For example, a first graphene layer is deposited on the layered structure, with the first graphene layer subsequently removed. The layered structure is then re-used to deposit a further graphene layer on the layered structure.

It is a further object of the invention to provide a layered structure that allows for a faster growth rate of a graphene layer on the layered structure.

It is a further object of the invention to provide a layered structure that allows for the obtaining of a graphene layer, wherein the layered structure has a reduced dewetting during the process of obtaining the graphene layer.

It is a further object of the invention to provide a layered structure that allows for the obtaining of a graphene layer, wherein the layered structure further allows for a reduction in the chemicals (such as catalysts) required to obtain the graphene layer.

It is a further object of the invention to provide a layered structure that allows for the obtaining of a graphene layer that has an improved quality.

It is a further object of the invention to provide a layered structure that allows for the obtaining of a graphene layer that has less defects.

It is a further object of the invention to provide a layered structure that allows for the obtaining of a graphene layer that has less wrinkles.

It is a further object of the invention to provide a layered structure that allows for the obtaining of a graphene layer that has a lower surface roughness.

It is a further object of the invention to provide a layered structure that allows for the obtaining of a graphene layer that has a lower doping level.

It is a further object of the invention to provide a method for obtaining a graphene layer.

It is a further object of the invention to provide a method for obtaining a graphene layer, wherein the method allows for a faster production of the graphene layer.

It is a further object of the invention to provide a method for obtaining a graphene layer, wherein the method requires less energy.

It is a further object of the invention to provide a method for obtaining a graphene layer, wherein the method has an increased graphene growth rate.

It is a further object of the invention to provide a method for obtaining a graphene layer, wherein the method requires less chemicals (such as catalysts).

It is a further object of the invention to provide a method for obtaining a graphene layer, wherein said graphene layer has an improved quality. A graphene layer has an improved quality when, *e.g.,* the graphene layer has a less wrinkles, a reduced average wrinkle height, less folds, increased electron mobility, reduced sheet resistance.

It is a further object of the invention to provide a method for obtaining a graphene layer that has less defects.

It is a further object of the invention to provide a method for obtaining a graphene layer that has a lower surface roughness.

It is a further object of the invention to provide a method for obtaining a graphene layer that has a lower doping level.

It is a further object of the invention to provide a graphene layer.

It is a further object of the invention to provide a graphene layer with improved quality.

It is a further object of the invention to provide a graphene layer that has less wrinkles.

It is a further object of the invention to provide a graphene layer that has less defects.

It is a further object of the invention to provide a graphene layer that has a lower surface roughness.

It is a further object of the invention to provide a graphene layer that has a lower doping level.

It is a further object of the invention to provide a graphene layer that has a reduced average wrinkle height.

It is a further object of the invention to provide a graphene layer that has less folds.

It is a further object of the invention to provide a graphene layer that has an increased electron mobility.

It is a further object of the invention to provide a graphene layer that has reduced residual charge carrier fluctuations.

It is a further object of the invention to provide a graphene layer that can be used for more applications. For example, the graphene layer can be used in a larger number of different electronic device types.

### PREFERRED EMBODIMENTS OF THE INVENTION

A contribution to at least partially fulfilling at least one of the above-mentioned objects is made by any of the embodiments of the invention.

A 1^{st} embodiment of the invention is a first layered structure comprising
a. a first layer, wherein
   i. the first layer comprises a first metal and at least one other chemical element, wherein the at least one other chemical element is preferably at least one further metal,
   ii. the first layer has a first section, wherein the first section has a crystal orientation that lies in a first crystal plane;
   iii. the Miller index ℓ, used to define the crystal lattice planes, is arranged perpendicular to a surface of the first layer;
   wherein
   a first angle between the first crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°.

In an aspect of the 1^{st} embodiment, it is preferred that the first metal and the at least one other chemical element are either in elementary form or in chemically bound form. In an aspect of the 1^{st} embodiment, it is preferred that the first metal and the at least one other chemical element form a chemical compound, *i.e.,* the first metal and the at least one other chemical element are in chemically bound form. A particularly preferred example of the first metal and the at least one other chemical element being in chemically bound form is an alloy of the first metal and the at least one other chemical element. In an aspect of the 1^{st} embodiment, it is preferred that the first section makes up at least 50 vol-%, more preferably at least 70 vol-%, even more preferably at least 85 vol-%, and further preferably at least 95 vol-% of the total volume of the first layer. In an aspect of the 1^{st} embodiment, it is preferred that the first angle is a dihedral angle between the first crystal plane and the (168)-plane. In an aspect of the 1^{st} embodiment, it is preferred that the first crystal plane is a (168)-plane or a (169)-plane. In an aspect of the 1^{st} embodiment, the first section should preferably be understood as having a single crystal structure.

In a preferred embodiment of the first layered structure, the first layer comprises a first alloy, and wherein the first alloy comprises at least one or all of the following: silicon, sulphur, iron, cobalt, nickel, copper, germanium, molybdenum, ruthenium, rhodium, palladium, tin, tungsten, rhenium, iridium, platinum, gold, a combination of at least two thereof. This preferred embodiment is a 2^{nd} embodiment of the invention, that preferably depends on the 1^{st} embodiment of the invention.

In the 2^{nd} embodiment the first alloy is an example of the first metal and the at least one other chemical element in chemically bound form, *i.e.,* forming a chemical compound. In the 2^{nd} embodiment, examples of an alloy include a nickel-molybdenum alloy, a copper-silicon alloy, a platinum-silicon alloy, a nickel-gold alloy, a nickel-titanium alloy, a copper-cobalt alloy, and a copper-nickel alloy. In an aspect of the 2^{nd} embodiment, it is particularly preferred that the first alloy is a copper-nickel alloy.

In a preferred embodiment of the first layered structure, the first layer comprises a first alloy, wherein the first alloy comprises at least one or all of the following:
a. in the range of 60 wt-% to 99 wt-%, preferably in the range of 67 wt-% to 93 wt-%, more preferably in the range of 72 wt-% to 88 wt-%, and further preferably in the range of 77 wt-% to 83 wt-% copper, where the wt-% are based on a total weight of the first layer;
b. in the range of 1 wt-% to 40 wt-%, preferably in the range of 7 wt-% to 33 wt-%, more preferably in the range of 12 wt-% to 28 wt-%, and further preferably in the range of 17 wt-% to 23 wt-% nickel, where the wt-% are based on a total weight of the first layer.

This preferred embodiment is a 3^{rd} embodiment of the invention, that preferably depends on any of the 1^{st} to 2^{nd} embodiments of the invention.

In the 3^{rd} embodiment, the first alloy is an example of the first metal and the at least one other chemical element in chemically bound form, *i.e.,* forming a chemical compound. In an aspect of the 3^{rd} embodiment, all possible combination of the features a. and b. are preferred aspects of the embodiment. These combinations are *e.g.,* a; b; a+b. In this aspect, the combination a+b is particularly preferred. In an aspect of the 3^{rd} embodiment, if the first layer comprises both copper and nickel (*i.e.,* the combination a+b), then it is not a requirement that the sum of the wt-% of copper and nickel should add up to 100 wt-%. For example, the first alloy may comprise 80 wt-% copper, 19 wt-% nickel, and 1 wt-% of one or more other chemical elements. In an aspect of the 3^{rd} embodiment, it is preferred that the first alloy comprises copper, nickel, and less than 5 wt-%, preferably less than 3 wt-%, and more preferably less than 1 wt-%, of at least one other chemical element.

In a preferred embodiment of the first layered structure, the first layer has a thickness in the range of 0.01 µm to 30 µm, preferably in the range of 0.05 µm to 20 µm, more preferably in the range of 0.1 µm to 15 µm, even more preferably in the range of 0.2 µm to 5 µm, further preferably in the range of 0.4 µm to 3 µm, and even further preferably in the range of 0.6 µm to 1 µm. This preferred embodiment is a 4^{th} embodiment of the invention, that preferably depends on any of the 1^{st} to 3^{rd} embodiments of the invention.

In a preferred embodiment of the first layered structure, at least 50 vol-%, more preferably at least vol-70 %, further preferably at least 85 %, and even further preferably at least 95 vol-% of the first layer has a single crystal structure. This preferred embodiment is a 5^{th} embodiment of the invention, that preferably depends on any of the 1^{st} to 4^{th} embodiments of the invention.

In a preferred embodiment of the first layered structure, the first layer has a surface roughness Rq that is in the range of 0.05 nm to 1 nm, preferably in the range of 0.1 nm to 0.6 nm, and more preferably in the range of 0.1 nm to 0.3 nm. This preferred embodiment is a 6^{th} embodiment of the invention, that preferably depends on any of the 1^{st} to 5^{th} embodiments of the invention.

In a preferred aspect of the invention, preferably in an aspect of the 6^{th} embodiment of the invention, a difference between a minimum surface roughness *Rqₘᵢₙ* and a maximum surface roughness *Rqₘₐₓ* of the first layer, measured over a distance and/or scale of 10 µm, is less than 10 nm, more preferably less than 5 nm, and further preferably less than 3 nm.

In a preferred embodiment of the first layered structure, the first layered structure further comprises a further layer, wherein
a. the first layer is superimposed on the further layer, and
b. the further layer comprises at least one or all of the following: at least one further alloy, at least one oxide, at least one nitride, at least one carbide, at least one element from group III of the periodic table, at least one element from group IV of the periodic table, at least one element from group V of the periodic table, a combination of two or more thereof.

This preferred embodiment is a 7^{th} embodiment of the invention, that preferably depends on any of the 1^{st} to 6^{th} embodiments of the invention.

In an aspect of the 7^{th} embodiment, it is particularly preferred that the further layer comprises at least one oxide. In an aspect of the 7^{th} embodiment, it is particularly preferred that the further layer comprises at least one or all of the following: magnesium oxide, aluminium oxide (e.g., sapphire), a combination thereof. In this aspect magnesium oxide is particularly preferred.

In a preferred embodiment of the first layered structure, the first layer touches the further layer. This preferred embodiment is an 8^{th} embodiment of the invention, that preferably depends on the 7^{th} embodiment of the invention.

In a preferred embodiment of the first layered structure, the further layer is adapted and arranged to impose a crystal orientation on the first layer. This preferred embodiment is a 9^{th} embodiment of the invention, that preferably depends on any of the 7^{th} to 8^{th} embodiments of the invention.

In a preferred embodiment of the first layered structure, the further layer has a further section, wherein the further section has a crystal orientation that lies in a further crystal plane, wherein a further angle between the further crystal plane and the (168)-plane is in the range of - 18° to 18°, preferably in the range of -12° to 12°, more preferably in the range of -8° to 8°, and further preferably in the range of -5° to 5°, and even further preferably in the range of -4° to 4°. This preferred embodiment is a 10^{th} embodiment of the invention, that preferably depends on any of the 7^{th} to 9^{th} embodiments of the invention.

In the 10^{th} embodiment, the Miller index ℓ, used to define the crystal lattice planes of the further layer, should preferably be understood to be arranged perpendicular to a surface of the first layer. In an aspect of the 10^{th} embodiment, it is preferred that the further section makes up at least 50 vol-%, more preferably at least 70 vol-%, even more preferably at least 85 vol-%, and further preferably at least 95 vol-% of the total volume of the further layer. In an aspect of the 10^{th} embodiment, it is preferred that the further angle is a dihedral angle between the further crystal plane and the (168)-plane. In an aspect of the 10^{th} embodiment, it is preferred that the further crystal plane is a (168)-plane or a (169)-plane. In an aspect of the 10^{th} embodiment, the further section should preferably be understood as having a single crystal structure.

In a preferred embodiment of the first layered structure, the further layer has a further section, wherein the further section has a crystal orientation that lies in the further crystal plane, and wherein an even-further angle between the first crystal plane and the further crystal plane is in the range of -25° to 25°, preferably in the range of -20° to 20°, more preferably in the range of -15° to 15°, further preferably in the range of -10° to 10°, further preferably in the range of - 5° to 5°, further preferably in the range of -3° to 3°, and even further preferably in the range of -1° to 1°. This preferred embodiment is an 11^{th} embodiment of the invention, that preferably depends on any of the 7^{th} to 10^{th} embodiments of the invention.

In an aspect of the 11^{th} embodiment, it is preferred that the even-further angle is a dihedral angle between the first crystal plane and the further crystal plane.

In a preferred embodiment of the first layered structure, the further layer comprises at least one or all of the following:
a. at least one oxide selected from the group consisting of magnesium oxide, silicon dioxide, zirconium oxide, aluminium oxide, a combination of at least two thereof;
b. at least one of the following: silicon, germanium, silicon carbide, a combination of at least two thereof;
c. at least one nitride selected from the group consisting of gallium nitride, boron nitride, a combination of at least two thereof;
d. at least one chemical compound comprising at least one element from group III of the periodic table and at least one element from group V of the periodic table.

This preferred embodiment is a 12^{th} embodiment of the invention, that preferably depends on any of the 7^{th} to 11^{th} embodiments of the invention.

In an aspect of the 12^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 12^{th} embodiment, a preferred boron nitride is hexagonal boron nitride. In an aspect of the 12^{th} embodiment, it is particularly preferred that the further layer comprises at least one or all of the following: magnesium oxide, aluminium oxide (e.g., sapphire), a combination thereof. In this aspect magnesium oxide is particularly preferred.

In a preferred embodiment of the first layered structure, at least 50 vol-%, more preferably at least vol-70 %, further preferably at least 85 %, and even further preferably at least 95 vol-% of the further layer has a single crystal structure. This preferred embodiment is a 13^{th} embodiment of the invention, that preferably depends on any of the 7^{th} to 12^{th} embodiments of the invention.

In a preferred embodiment of the first layered structure, the further layer has a thickness in the range of 100 µm to 2 mm, preferably in the range of 200 µm to 800 µm, more preferably in the range of 400 µm to 600 µm, and further preferably in the range of 450 µm to 550 µm . This preferred embodiment is a 14^{th} embodiment of the invention, that preferably depends on any of the 7^{th} to 13^{th} embodiments of the invention.

In a preferred embodiment of the first layered structure, a ratio of a thermal expansion coefficient of the first layer to a thermal expansion coefficient of the further layer is in the range of 0.1 to 2.5, preferably in the range of 0.4 to 1.7, more preferably in the range of 0.7 to 1.3, and further preferably in the range of 0.9 to 1.1. This preferred embodiment is a 15^{th} embodiment of the invention, that preferably depends on any of the 7^{th} to 14^{th} embodiments of the invention.

In a preferred embodiment of the first layered structure, a surface of the first layer, a surface of the further layer, or both, comprise a plurality of terraces, wherein a size of at least 50 % of the terraces vary by less than 30 %, more preferably less than 20 %, and further preferably less than 10 % from an average size of the plurality of terraces. This preferred embodiment is a 16^{th} embodiment of the invention, that preferably depends on any of the 1^{st} to 15^{th} embodiments of the invention.

In the 16^{th} embodiment, terraces should preferably be understood as at least two adjacent regions in the surface of a layer, wherein the at least two regions have different heights.

A 17^{th} embodiment of the invention is a further layered structure comprising
a. a first layer, wherein
   i. the first layer comprises a first metal and at least one other chemical element, wherein the at least one other chemical element is preferably at least one further metal,
   ii. the first layer has a first section, wherein the first section has a crystal orientation that lies in a second crystal plane;
   iii. the Miller index ℓ, used to define the crystal lattice planes, is arranged perpendicular to a surface of the first layer;
   wherein
   a second angle between the second crystal plane and the (1 1 1)-plane is in the range of -18° to 18°, preferably in the range of -12° to 12°, more preferably in the range of -8° to 8°, further preferably in the range of -5° to 5°, and even further preferably in the range of -4° to 4°.

In an aspect of the 17^{th} embodiment, the 2^{nd} to 16^{th} preferred embodiments, and their preferred aspects, are also preferred embodiments and preferred aspects, *mutatis mutandis,* of the 17^{th} embodiment of the invention. In an aspect of the 17^{th} embodiment, it is preferred that the first metal and the at least one other chemical element are either in elementary form or in chemically bound form. In an aspect of the 17^{th} embodiment, it is preferred that the first metal and the at least one other chemical element form a chemical compound, *i.e.,* the first metal and the at least one other chemical element are in chemically bound form. A particularly preferred example of the first metal and the at least one other chemical element being in chemically bound form is an alloy of the first metal and the at least one other chemical element. In an aspect of the 17^{th} embodiment, it is preferred that the first section makes up at least 50 vol-%, more preferably at least at least 70 vol-%, even more preferably at least 85 vol-%, and further preferably at least 95 vol-% of the total volume of the first layer. In an aspect of the 17^{th} embodiment, it is preferred that the second angle is a dihedral angle between the second crystal plane and the (11 1)-plane. In an aspect of the 17^{th} embodiment, it is preferred that the second crystal plane is a (11 1)-plane. In an aspect of the 17^{th} embodiment, the first section should preferably be understood as having a single crystal structure.

In a preferred embodiment of the further layered structure, the thickness of the first layer is less than 600 nm, more preferably less than 500 nm, and further preferably less than 400 nm. This preferred embodiment is an 18^{th} embodiment of the invention, that preferably depends on the 17^{th} embodiment of the invention.

In a preferred embodiment of the further layered structure, the further layered structure further comprises a further layer, wherein the first layer is superimposed on the further layer. This preferred embodiment is a 19^{th} embodiment of the invention, that preferably depends on any of the 17^{th} to 18^{th} embodiments of the invention.

In an aspect of the 19^{th} embodiment, it is preferred that that further layer comprises an oxide, more preferably aluminium oxide, even more preferably α-Al₂O₃, and further preferably sapphire.

In a preferred embodiment of the further layered structure, the further layer has a further section, wherein the further section has a crystal orientation that lies in a third crystal plane, wherein a third angle between the third crystal plane and the (0001)-plane is in the range of-18° to 18°, preferably in the range of -12° to 12°, more preferably in the range of -8° to 8°, and further preferably in the range of -5° to 5°, and even further preferably in the range of -4° to 4°. This preferred embodiment is a 20^{th} embodiment of the invention, that preferably depends on any of the 17^{th} to 19^{th} embodiments of the invention.

In the 20^{th} embodiment, the Miller index ℓ, used to define the crystal lattice planes of the further layer, should preferably be understood to be arranged perpendicular to a surface of the first layer. In an aspect of the 20^{th} embodiment, it is preferred that the further section makes up at least 50 vol-%, more preferably at least at least 70 vol-%, even more preferably at least 85 vol-%, and further preferably at least 95 vol-% of the total volume of the further layer. In an aspect of the 20^{th} embodiment, it is preferred that the (0001)-plane is with respect to a C-axis (or optical axis) of the further layer. In an aspect of the 20^{th} embodiment, it is preferred that the third angle is a dihedral angle between the third crystal plane and the (0001)-plane. In an aspect of the 20^{th} embodiment, it is preferred that the third crystal plane is a (0001)-plane. In an aspect of the 20^{th} embodiment, the further section should preferably be understood as having a single crystal structure.

In a preferred aspect of the invention, the first layered structure is more preferred that the further layered structure.

A 21^{st} embodiment of the invention is a method for producing a layered structure according to the invention, preferably a layered structure according to any of the 1^{st} to 20^{th} embodiments of the invention, more preferably a first layered structure according to any of the 1^{st} to 16^{th} embodiments of the invention, comprising the steps of:
a. optionally, providing a further layer, preferably a further layer according to any of the 7^{th} to 16^{th} embodiments of the invention;
b. depositing the first layer, preferably by superimposing the first layer on the further layer, to obtain the layered structure.

The 21^{st} embodiment should preferably be understood as a method for producing a first layered structure according to the invention, a method for producing a further layered structure according to the invention, or both.

In a preferred embodiment of the method for producing a layered structure, the first layer is deposited on the further layer such that the further layer and the first layer touch each other. This preferred embodiment is a 22^{nd} embodiment of the invention, that preferably depends on the 21^{st} embodiments of the invention.

In a preferred embodiment of the method for producing a layered structure, the first layer is deposited using at least one or all of the following:
a. chemical vapour deposition;
b. physical vapour deposition;
c. atomic layer deposition.

This preferred embodiment is a 23^{rd} embodiments of the invention, that preferably depends on any of the 21^{st} to 22^{nd} embodiments of the invention.

In an aspect of the 23^{rd} embodiment, all possible combination of the features a. to c. are preferred aspects of the embodiment. These combinations are *e.g.,* a; b; c; a+b; a+c; b+c; a+b+c. In an aspect of the 23^{rd} embodiment, physical vapour deposition is particularly preferred.

In a preferred embodiment of the method for producing a layered structure, the method further comprises the step of subjecting the layered structure to heat treatment. This preferred embodiment is a 24^{th} embodiments of the invention, that preferably depends on any of the 21^{st} to 23^{rd} embodiments of the invention.

In a preferred embodiment of the method for producing a layered structure, at least one or all of the following applies:
a. the heat treatment is performed at a temperature that is at least 50 °C, preferably at least 75 °C, and more preferably at least 100 °C below the melting point of the first layer, the further layer, or both.
b. the heat treatment is performed at a temperature that is in the range of 200 °C to 2400 °C, preferably in the range of 200 °C to 2000 °C, more preferably in the range of 250 °C to 1600 °C, even more preferably in the range of 250 °C to 1300 °C, even more preferably in the range of 300 °C to 1100 °C, further preferably in the range of 300 °C to 1000 °C, and even further preferably in the range of 400 °C to 900 °C.

This preferred embodiment is a 25^{th} embodiments of the invention, that preferably depends on the 24^{th} embodiment of the invention.

In an aspect of the 25^{th} embodiment, all possible combination of the features a. and b. are preferred aspects of the embodiment. These combinations are *e.g.,* a; b; a+b. In an aspect of the 25^{th} embodiment, step b., it is preferred that the heat treatment is performed at a temperature that is in the range of 680 °C to 900 °C.

A 26^{th} embodiment of the invention is a method for producing at least one graphene layer, comprising the steps of
a. providing a layered structure according to the invention, preferably a layered structure according to any of the 1^{st} to 20^{th} embodiments of the invention, more preferably a first layered structure according to any of the 1^{st} to 16^{th} embodiments of the invention, or preferably a layered structure obtainable by the method for producing a layered structure according to any of the 21^{st} to 25^{th} embodiments of the invention;
b. placing the layered structure in a cavity;
c. heating the layered structure in the presence of a gaseous carbon precursor in the cavity, thereby obtaining the at least one graphene layer, and wherein the at least one graphene layer is superimposed on the layered structure, preferably the first layer,
wherein
a temperature in the cavity is in the range of 300 °C to 2000 °C, preferably in the range of 400 °C to 1700 °C, more preferably in the range of 500 °C to 1500 °C, even more preferably in the range of 600 °C to 1300 °C, further preferably in the range of 600 °C to 900 °C, further preferably in the range of 670 °C to 830 °C, further preferably in the range of 700 °C to 800 °C, and even further preferably in the range of 730 °C to 770 °C.

In an aspect of the 26^{th} embodiment, it is particularly preferred that a first layered structure according to the invention is provided, and even more particularly preferred that a first layered structure according to any of the 1^{st} to 16^{th} embodiments of the invention is provided. In an aspect of the 26^{th} embodiment, it is preferred that the cavity forms part of a reactor adapted and arranged for chemical vapour deposition, physical vapour deposition, or both. An example of such a reactor is a quartz tube furnace. In an aspect of the 26^{th} embodiment, it is preferred that the at least one graphene layer touches the layered structure, more preferably touches the first layer. In an aspect of the 26^{th} embodiment, step c., it is preferred that a single graphene layer, superimposed on the layered structure, is obtained. In an aspect of the 26^{th} embodiment, the following temperature ranges are particularly preferred: a temperature in the range of 651 °C to 900 °C, more preferably in the range of 670 °C to 830 °C, further preferably in the range of 700 °C to 800 °C, and even further preferably in the range of 730 °C to 770 °C.

In a preferred embodiment of the method for producing at least one graphene layer, a pressure in the cavity is in the range of 10⁻³ mbar to 1000 mbar, preferably in the range of 10⁻² mbar to 100 mbar, more preferably in the range of 10⁻¹ mbar to 10 mbar. This preferred embodiment is a 27^{th} embodiments of the invention, that preferably depends on the 26^{th} embodiment of the invention.

In a preferred embodiment of the method for producing at least one graphene layer, the at least one graphene layer is obtained using at least one or all of the following:
a. chemical vapour deposition, *e.g.,* plasma enhanced chemical vapour deposition, metalorganic chemical vapour deposition;
b. physical vapour deposition.

This preferred embodiment is a 28^{th} embodiments of the invention, that preferably depends on any of the 26^{th} to 27^{th} embodiments of the invention.

In an aspect of the 28^{th} embodiment, all possible combination of the features a. and b. are preferred aspects of the embodiment. These combinations are *e.g.,* a; b; a+b.

In a preferred embodiment of the method for producing at least one graphene layer, the carbon precursor is selected from the group consisting of ethylene, acetylene, methane, toluene, benzene, camphor, at least one natural oil, at least one alcohol, carbon dioxide, coal char, lard, at least one alkane, ethane, a polysaccharide (*e.g.,* cellulose, starch), a combination of at least two thereof. This preferred embodiment is a 29^{th} embodiments of the invention, that preferably depends on any of the 26^{th} to 28^{th} embodiments of the invention.

In an aspect of the 29^{th} embodiment, it is particularly preferred that the carbon precursor is ethylene, acetylene, methane, or a combination of at least two thereof. Examples of preferred natural oils in the 29^{th} embodiment include sesame oil and palm oil. Examples of preferred alcohols in the 29^{th} embodiment include methanol, ethanol, and 1-propanol, 2-phenylethanol. Examples of preferred alkanes in the 29^{th} embodiment include methane, butane and propane. A preferred combination of methane and butane is liquefied petroleum gas. Examples of a polysaccharide is cellulose and starch.

In a preferred embodiment of the method for producing at least one graphene layer, the layered structure is heated in the presence of at least one or all of the following: a noble gas (*e.g.,* argon), hydrogen, nitrogen, a combination of at least two thereof. This preferred embodiment is a 30^{th} embodiments of the invention, that preferably depends on any of the 26^{th} to 29^{th} embodiments of the invention.

In a preferred embodiment of the method for producing at least one graphene layer, the layered structure, with the at least one graphene layer superimposed thereon, is subjected to an intercalation step, thereby forming at least one intercalation layer between the layered structure and the at least one graphene layer. This preferred embodiment is a 31^{st} embodiments of the invention, that preferably depends on any of the 26^{th} to 30^{th} embodiments of the invention.

In an aspect of the 31^{st} embodiment, it is preferred that the intercalation step is performed after the layered structure, with the at least one graphene layer superimposed thereon, has been removed from the cavity. *E.g.,* the intercalation step is performed outside the cavity.

In a preferred embodiment of the method for producing at least one graphene layer, the method further comprises the step of at least partially removing the at least one graphene layer from the layered structure. This preferred embodiment is a 32^{nd} embodiments of the invention, that preferably depends on any of the 26^{th} to 31^{st} embodiments of the invention.

In an aspect of the 32^{nd} embodiment, it is preferred to at least partially remove the at least one graphene layer after the layered structure, with the at least one graphene layer superimposed thereon, has been removed from the cavity. E.g., the at least one graphene layer is at least partially removed outside the cavity.

In a preferred embodiment of the method for producing at least one graphene layer, the at least one graphene layer is at least partially removed using at least one or all of the following: wet transfer, quasi-dry transfer, dry transfer, electrochemical transfer, or a combination of at least two thereof. This preferred embodiment is a 33^{rd} embodiments of the invention, that preferably depends on the 32^{nd} embodiment of the invention.

In a preferred embodiment of the method for producing at least one graphene layer, the method further comprises the step of reusing the layered structure to obtaining at least one further graphene layer superimposed on the layered structure. This preferred embodiment is a 34^{th} embodiments of the invention, that preferably depends on any of the 32^{nd} to 33^{rd} embodiments of the invention.

An example of the 34^{th} embodiment is the following: the method for producing at least one graphene layer, according to any of the 26^{th} to 31^{st} embodiments, is performed, thereby obtaining at least one graphene layer that is superimposed on the layered structure. The layered structure is subjected to any of the 32^{nd} to 33^{rd} embodiments to remove the at least one layer of graphene from the layered structure. The method for producing at least one graphene layer, according to any of the 26^{th} to 31^{st} embodiments, is then repeated using the same layered structure, thereby again obtaining at least one graphene layer (*i.e.,* at least one further graphene layer) that is superimposed on the layered structure. The layered structure is again subjected to any of the 32^{nd} to 33^{rd} embodiments to remove the at least one further layer of graphene from the layered structure. It is preferred to repeat this example multiple times using the same layered structure.

A 35^{th} embodiment is a layered structure according to the invention, preferably a layered structure according to any of the 1^{st} to 20^{th} embodiments of the invention, or preferably a layered structure obtainable by the method for producing a layered structure according to any of the 21^{st} to 25^{th} embodiments of the invention, wherein the layered structure further comprises at least one graphene layer, preferably at least one graphene layer superimposed on the first layer.

In an aspect of the 35^{th} embodiment, it is particularly preferred that the layered structure is a first layered structure according to the invention, and even more particularly preferred a first layered structure according to any of the 1^{st} to 16^{th} embodiments of the invention. In an aspect of the 35^{th} embodiment, it is preferred that the layered structure further comprises an intercalation layer arranged between the first layer and the at least one graphene layer. A preferred intercalation layer comprises water. In an aspect of the 35^{th} embodiment, it is preferred that the layered structure comprises a single graphene layer.

A 36^{th} embodiment of the invention is a method, comprising the steps of
a. providing a layered structure according to the invention, with at least one graphene layer superimposed on the first layer, preferably a layered structure according to the 35^{th} embodiment of the invention;
b. at least partially removing the at least one graphene layer.

In an aspect of the 36^{th} embodiment, it is preferred that the at least one graphene layer is at least partially removed using at least one or all of the following: wet transfer, quasi-dry transfer, dry transfer, electrochemical transfer, or a combination of at least two thereof.

A 37^{th} embodiment of the invention is a graphene layer, preferably a graphene layer obtainable by a method according to the invention, more preferably a graphene layer obtainable according to any of the 26^{th} to 34^{th}, and 35^{th} embodiments of the invention.

In an aspect of the 37^{th} embodiment, it is preferred that the graphene layer is in the form of a plurality of fragments, *e.g.,* flakes.

In a preferred embodiment of the graphene layer, the graphene layer has at least one or all of the following properties:
a. less than 20 %, preferably less than 15 %, more preferably less than 10 %, and further preferably less than 5 % of a surface area of the graphene layer has folds;
b. less than 20 %, preferably less than 15 %, more preferably less than 10 %, and further preferably less than 5 % of the surface area of the graphene layer has wrinkles;
c. a maximum wrinkle height of, of wrinkles present in the graphene layer, is less than 50 nm, preferably less than 35 nm, more preferably less than 20 nm, even more preferably less than 10 nm, further preferably less than 5 nm, and even further preferably less than 2 nm.

This preferred embodiment is a 38^{th} embodiments of the invention, that preferably depends on the 37^{th} embodiment of the invention.

In an aspect of the 38^{th} embodiment, all possible combination of the features a. to c. are preferred aspects of the embodiment. These combinations are *e.g.,* a; b; c; a+b; a+c; b+c; a+b+c.

A 39^{th} embodiment of the invention is an electrical component comprising a graphene layer according to the invention, preferably a graphene layer according to any of the 37^{th} to 38^{th} embodiments of the invention.

In a preferred embodiment of the electrical component, the electrical component is selected from the group consisting of: a semiconductor component (*e.g.,* a transistor, a graphene based field effect transistor, a radio frequency graphene based field effect transistor); an opto-electronic component (*e.g.,* a modulator, a photo-detector, a broad spectrum photo-detector, a single photon photo-detectors); a waveguide; a heating component (*e.g.,* a graphene heater); a measuring component (*e.g.,* a device comprising a hall bar); a sensor (*e.g.,* a pressure sensor, a gas sensor, a magnetic sensor, an ion sensor); an accelerometer; a detector adapted and arranged for the detection of viruses, antibodies, biomarkers, biomolecules, and/or a combination of at least two thereof; quantum dots; a microwave circuit; an antenna (*e.g.,* a THz antenna); a combination of at least two thereof. This preferred embodiment is a 40^{th} embodiments of the invention, that preferably depends on the 39^{th} embodiment of the invention.

A 41^{st} embodiment of the invention is a use of a layered structure according to the invention, preferably a layered structure according to any of the 1^{st} to 20^{th} embodiments of the invention, or preferably a layered structure obtainable by the method for producing a layered structure according to any of the 21^{st} to 25^{th} embodiments of the invention, for producing at least one graphene layer, preferably for producing a single graphene layer.

In an aspect of the 41^{st} embodiment, it is preferred that the layered structure is a first layered structure according to the invention, more preferably a first layered structure according any of the 1^{st} to 16^{th} embodiments of the invention.

A 42^{nd} embodiment of the invention is a use of a graphene layer according to the invention, preferably a graphene layer according to any of the 37^{th} to 38^{th} embodiments of the invention, in an electrical component, preferably to improve at least one property of the electrical component.

In an aspect of the 42^{nd} embodiment, it is preferred that the electrical component is selected from the group of electrical components of the 40^{th} embodiment of the invention. In an aspect of the 42^{nd} embodiment, it is preferred that the graphene layer is in the form of a plurality of fragments, *e.g.,* flakes. In an aspect of the 42^{nd} embodiment, the at least one property includes at least one or all of the following: bit rate, insertion loss, energy usage, responsivity, a combination of at least two thereof. The aforementioned properties should preferably be understood as follows: bitrate is the rate of data flow in digital networks, typically measured in bits per second; insertion loss is unwanted loss in an intensity of electromagnetic waves propagating in a waveguide of a photodetector; energy usage is the energy required to operate the electrical component; responsivity is a ratio of current output by a photodetector to optical power of electromagnetic waves propagating in a waveguide of the photodetector.

### DETAILED DESCRIPTION OF THE INVENTION

Throughout this document, disclosures of ranges should preferably be understood to include both end points of the range. Furthermore, each disclosure of a range in the document should preferably be understood as also disclosing preferred sub-ranges in which one end point is excluded or both end points are excluded. For example, a disclosure of a range from *X₁* to *X₂* is to be understood as disclosing a range that includes both of the end points *X₁* and *X₂.* Furthermore, it is to be understood as also disclosing a range that includes the end point *X₁* but excludes the end point *X₂,* a range that excludes the end point *X₁* but includes the end point *X₂,* and a range that excludes both end points *X₁* and *X₂.*

Some preferred embodiments and preferred aspects have various combinations of features as alternatives. Where the various combinations are disclosed, these combinations are separated by a semi-colon (";"). For example, the list "a; a+b; a+c+d" should be understood to disclose a preferred embodiment that comprises the feature "a", an alternative of the preferred embodiment that comprises the features "a" and "b", and a further alternative of the preferred embodiment that comprises the features "a", "c", and "d".

Throughout this document, ranges and multiple preferred ranges are disclosed for a number of features. Any of the ranges of one feature may be combined with any of the ranges of another feature.

Throughout this document, the wording "first", "second", "third", "further" and "even-further" is used to distinguish features from each other and should preferably not be understood to indicate the number of features present in a component (*e.g.,* the first layer). For example, in the 17^{th} embodiment of the invention, the first section of the first layer has a crystal orientation that lies in a second crystal plane. Here the wording "second" should preferably not be understood to indicate that said first section also has an orientation that lies in a "first" crystal plane. Rather, the wording "second" is used to distinguish the second crystal plane of the further layered structure from the first crystal plane of the first layered structure. The above also applies to, *e.g.,* angles (such as the first angle and the second angle).

Features described as preferred in one category of the invention, for example the first layered structure, are analogously preferred in embodiments of the other categories according to the invention, such as the methods and the uses.

### Layers

Examples of "a layer" are a first layer, a further layer, and a graphene layer. Therefore, throughout this document, where reference is made to a layer without any qualification (examples of a qualification include "first", "further", "graphene"), this should preferably be understood as disclosing at least one or all of the following: a first layer, a further layer, a graphene layer. For example, if it is disclosed that a layer may be deposited using chemical vapour deposition, this should preferably be understood as disclosing that at least one or all of the following may be deposited using chemical vapour deposition: a first layer, a further layer, a graphene layer.

Throughout this document, "layer X", "layer Y", and "layer Z" are used to distinguish between different layers in a given context. Examples of the layers X, Y, and Z include a first layer, a further layer, and a graphene layer. For example, if it is disclosed that layer Y is superimposed on layer X, this should be understood to disclose, *inter alia,* the following: a first layer superimposed on a further layer; a graphene layer superimposed on a first layer. Note that, *e.g.,* a layer X may represent a given layer in a first context, and a different layer in another context.

### First layer

In a preferred aspect of the invention, at least 50 vol-% of the first layer has a crystal orientation that lies in a first crystal plane, wherein a first angle between the first crystal plane and the (168)-plane is in the range of-18° to 18°, preferably in the range of-12° to 12°, more preferably in the range of -8° to 8°, further preferably in the range of -5° to 5°, and even further preferably in the range of -4° to 4°. This aspect should preferably be understood that the first layer has a first section that makes up at least 50 vol-% of the total volume of the first layer. This aspect is particularly preferred for the first layered structure.

In a preferred aspect of the invention, at least 70 vol-% of the first layer has a crystal orientation that lies in a first crystal plane, wherein a first angle between the first crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 70 vol-% of the total volume of the first layer. This aspect is particularly preferred for the first layered structure.

In a preferred aspect of the invention, at least 85 vol-% of the first layer has a crystal orientation that lies in a first crystal plane, wherein a first angle between the first crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 85 vol-% of the total volume of the first layer. This aspect is particularly preferred for the first layered structure.

In a preferred aspect of the invention, at least 95 vol-% of the first layer has a crystal orientation that lies in a first crystal plane, wherein a first angle between the first crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 90 vol-% of the total volume of the first layer. This aspect is particularly preferred for the first layered structure.

In a preferred aspect of the invention, at least 50 vol-% of the first layer has a crystal orientation that lies in a second crystal plane, wherein a second angle between the second crystal plane and the (11 1)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 50 vol-% of the total volume of the first layer. This aspect is particularly preferred for the further layered structure.

In a preferred aspect of the invention, at least 70 vol-% of the first layer has a crystal orientation that lies in a second crystal plane, wherein a second angle between the second crystal plane and the (11 1)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 70 vol-% of the total volume of the first layer. This aspect is particularly preferred for the further layered structure.

In a preferred aspect of the invention, at least 85 vol-% of the first layer has a crystal orientation that lies in a second crystal plane, wherein a second angle between the second crystal plane and the (11 1)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 85 vol-% of the total volume of the first layer. This aspect is particularly preferred for the further layered structure.

In a preferred aspect of the invention, at least 95 vol-% of the first layer has a crystal orientation that lies in a second crystal plane, wherein a second angle between the second crystal plane and the (11 1)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the first layer has a first section that makes up at least 95 vol-% of the total volume of the first layer. This aspect is particularly preferred for the further layered structure.

In a particularly preferred aspect of the invention, the first layer comprises a first alloy, wherein the first alloy comprises copper and nickel. In this aspect, it is preferred that the first alloy comprises in the range of 60 wt-% to 99 wt-%, preferably in the range of 67 wt-% to 93 wt-%, more preferably in the range of 72 wt-% to 88 wt-%, and further preferably in the range of 77 wt-% to 83 wt-% copper, and in the range of 1 wt-% to 40 wt-% nickel. The wt-% are based on a total weight of the first layer. It is particularly preferred that this aspect applies to the first layered structure.

In a particularly preferred aspect of the invention, the first layer comprises a first alloy, wherein the first alloy comprises copper and nickel. In this aspect, it is preferred that the first alloy comprises in the range of 60 wt-% to 99 wt-%, preferably in the range of 67 wt-% to 93 wt-%, more preferably in the range of 72 wt-% to 88 wt-%, and further preferably in the range of 77 wt-% to 83 wt-% copper, and in the range of 7 wt-% to 33 wt-% nickel. The wt-% are based on a total weight of the first layer. It is particularly preferred that this aspect applies to the first layered structure.

In a particularly preferred aspect of the invention, the first layer comprises a first alloy, wherein the first alloy comprises copper and nickel. In this aspect, it is preferred that the first alloy comprises in the range of 60 wt-% to 99 wt-%, preferably in the range of 67 wt-% to 93 wt-%, more preferably in the range of 72 wt-% to 88 wt-%, and further preferably in the range of 77 wt-% to 83 wt-% copper, and in the range of 12 wt-% to 28 wt-% nickel. The wt-% are based on a total weight of the first layer. It is particularly preferred that this aspect applies to the first layered structure.

In a particularly preferred aspect of the invention, the first layer comprises a first alloy, wherein the first alloy comprises copper and nickel. In this aspect, it is preferred that the first alloy comprises in the range of 60 wt-% to 99 wt-%, preferably in the range of 67 wt-% to 93 wt-%, more preferably in the range of 72 wt-% to 88 wt-%, and further preferably in the range of 77 wt-% to 83 wt-% copper, and in the range of 17 wt-% to 23 wt-% nickel. The wt-% are based on a total weight of the first layer. It is particularly preferred that this aspect applies to the first layered structure.

### Further layer

In a preferred aspect of the invention, at least 50 vol-% of the further layer has a crystal orientation that lies in a further crystal plane, wherein a further angle between the further crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the further layer has a further section that makes up at least 50 vol-% of the total volume of the further layer. This preferred aspect is particularly preferred for the first layered structure. This preferred aspect is also a preferred aspect, *mutatis mutandis,* of the third angle between the third crystal plane and the (0001)-plane of the further layered structure.

In a preferred aspect of the invention, at least 70 vol-% of the further layer has a crystal orientation that lies in a further crystal plane, wherein a further angle between the further crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the further layer has a further section that makes up at least 70 vol-% of the total volume of the further layer. This preferred aspect is particularly preferred for the first layered structure. This preferred aspect is also a preferred aspect, *mutatis mutandis,* of the third angle between the third crystal plane and the (0001)-plane of the further layered structure.

In a preferred aspect of the invention, at least 85 vol-% of the further layer has a crystal orientation that lies in a further crystal plane, wherein a further angle between the further crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the further layer has a further section that makes up at least 85 vol-% of the total volume of the further layer. This preferred aspect is particularly preferred for the first layered structure. This preferred aspect is also a preferred aspect, *mutatis mutandis,* of the third angle between the third crystal plane and the (0001)-plane of the further layered structure.

In a preferred aspect of the invention, at least 95 vol-% of the further layer has a crystal orientation that lies in a further crystal plane, wherein a further angle between the further crystal plane and the (168)-plane is in the range of -18° to 18°, preferably in the range of -12° to 12°, more preferably in the range of -8° to 8°, further preferably in the range of -5° to 5°, and even further preferably in the range of -4° to 4°. This aspect should preferably be understood that the further layer has a further section that makes up at least 95 vol-% of the total volume of the further layer. This preferred aspect is particularly preferred for the first layered structure. This preferred aspect is also a preferred aspect, *mutatis mutandis,* of the third angle between the third crystal plane and the (0001)-plane of the further layered structure.

In a preferred aspect of the invention, the further layer comprises at least one or all of the following: at least one further alloy, at least one oxide, at least one nitride, at least one carbide, at least one element from group III of the periodic table, at least one element from group IV of the periodic table, at least one element from group V of the periodic table, a combination of two or more thereof. In this aspect, preferred elements from group 14 of the periodic table are germanium and silicon. In this aspect, a chemical compound comprising at least two elements from group 14 of the periodic table, such as silicon carbide, are also preferred.

In a preferred aspect of the invention, the further layer comprises at least one chemical compound comprising at least one element from group III of the periodic table and at least one element from group V of the periodic table. Such a chemical compound is defined as a III-V chemical compound. Examples of a III-V chemical compound include aluminium antimonide, aluminium arsenide, aluminium gallium arsenide, aluminium gallium indium phosphide, aluminium gallium nitride, aluminium gallium phosphide, aluminium indium arsenide, aluminium nitride, aluminium phosphide, boron arsenide, boron nitride, boron phosphide, gallium antimonide, gallium arsenide, gallium arsenide phosphide, gallium indium arsenide antimonide phosphide, gallium nitride, gallium phosphide, indium aluminium nitride, indium antimonide, indium arsenide, indium arsenide antimonide phosphide, indium gallium aluminium nitride, indium gallium arsenide, indium gallium arsenide phosphide, indium gallium nitride, indium gallium phosphide, indium nitride, and indium phosphide.

In a preferred aspect of the invention, the further layer is adapted and arranged to impose a crystal orientation on the first layer. This should preferably be understood to mean that when the first layer is superimposed on the further layer, the crystal orientation of the further layer at least partially determines the crystal orientation of the first layer. For example, when a first layer that comprise Cu-Ni is deposited, using molecular beam epitaxy, on a further layer that comprises MgO, the crystal orientation of the first layer is determined by the crystal orientation of the further layer.

### Graphene layer

A preferred graphene layer has average room-temperature carrier mobilities of at least 3000 cm²/V, preferably at least 10000 cm²/V, more preferably at least 25000 cm²/V, and further preferably at least 40000 cm²/V, for a carrier density of 10¹² cm⁻².

A fold in a graphene layer should preferably be understood as a section of the graphene layer that is bent over on itself such that one part of the section covers another part of the section. A wrinkle in a graphene layer should preferably be understood as a section of the graphene layer that forms a ridge.

### Superimposed

If a layer Y (*e.g.,* a first layer, a graphene layer) is superimposed on a layer X (*e.g.,* a further layer, a first layer), this should preferably be understood to mean that the layer Y at least partially covers a surface of the layer X. However, this should not be understood to mean that 100 % of a surface area of the layer X is necessarily covered by the layer Y. *E.g.,* if layer Y is superimposed on a surface of layer X, then layer Y may cover 100 % of the surface area of a surface of layer X, or layer Y may cover less than 100 % of the surface area of a surface of layer X.

If a layer Y is superimposed on a layer X, then the layers Y and X may touch each other. However, if a layer Y is superimposed on a layer X, this should not be understood to mean that the layers X and Y necessarily have to touch each other. E.g., the layer Y is superimposed on the layer X, wherein a layer Z is arranged between the layers X and Y, *i.e.,* the layers X and Y both touch the layer Z, but the layers X and Y do not touch each other. E.g., the layer Y is superimposed on the layer X, and the layers X and Y touch other.

### Crystal plane

A lattice plane, as used in this document, should preferably be understood as a lattice plane in crystal Bravais lattices. A preferred first layer can be described by a cubic Bravais lattice.

Miller indices should preferably be understood as a notation system in crystallography for lattice planes in crystal Bravais lattices. Generally, a family of lattice planes of a given Bravais lattice is determined by three integers *h, k,* and ℓ, which are known as the Miller indices. Miller indices are preferably written as (*h, k, ℓ*). Examples of materials that can be described with the Miller indices (*h, k, ℓ*) include a copper-nickel alloy and magnesium oxide.

For materials that can be described using hexagonal and/or rhombohedral Bravais lattices, it is preferred to use the Miller indices (*h, k, i, ℓ*). An example of a material that can be described with the Miller indices (*h, k, i, ℓ*) is α-Al₂O₃. An example of a material that comprises α-Al₂O₃ is sapphire.

### Single crystal structure

If a section of a layer has a single crystal structure, this should preferably be understood as the section of the layer having no grain boundaries. For example, the structure of the crystal lattice is continuous and unbroken.

### Deposition

Various chemical vapour deposition (CVD) methods for depositing a layer (*e.g.,* a first layer, a further layer, a graphene layer) are well known in the art. Any CVD method, which the skilled person deems suitable for the present invention, may be used. These CVD methods include, but are not limited to, atmospheric pressure CVD (APCVD), low-pressure CVD (LPCVD), ultrahigh vacuum CVD (UHCVD), plasma-enhanced CVD (PECVD), atomic-layer deposition (ALD), and metalorganic CVD (MOCVD).

Various physical vapour deposition (PVD) methods for depositing a layer (*e.g.,* a first layer, a further layer, a graphene layer) are well known in the art. Any PVD method, which the skilled person deems suitable for the present invention, may be used. These PVD methods include, but are not limited to, sputtering deposition methods, evaporation deposition methods, and pulsed laser deposition. Evaporation deposition methods pertain to the evaporation and condensation of a chemical substance on, *e.g.,* a layer. Suitable sputtering deposition methods include, but are not limited to, high-power impulse magnetron sputtering, high-target-utilisation sputtering, ion beam sputtering, reactive sputtering, ion-assisted deposition, and gas flow sputtering.

In a preferred aspect of the invention, a layer (*e.g.,* a first layer, a graphene layer) is deposited via epitaxy, more preferably via molecular beam epitaxy.

The obtaining of the graphene layer should preferably be understood to include at least one or all of the following: the obtaining of the graphene layer on the layered structure, the removal of the graphene layer from the layered structure, or both. A graphene layer is preferably obtained on the layered structure by depositing the graphene layer on the layered structure. In this aspect, it is preferred that the graphene layer is deposited by growing the graphene layer on the layered structure. A graphene layer is preferably removed from the layered structure by a transfer method (also referred to as a delamination method).

### Carbon precursor

A gaseous carbon precursor should preferably be understood as a carbon precursor in the form of a gas. A preferred carbon precursor is an organic compound.

### Intercalation and removal of graphene layer

Various methods for the intercalation of a graphene layer superimposed on a layered structure are well known in the art. Any intercalation method, which the skilled person deems suitable for the present invention, may be used.

Various methods, for the at least partial removal (transfer) of a graphene layer from the layered structure, are well known in the art. Any removal method, which the skilled person deems suitable for the present invention, may be used. Examples of removal methods include mechanical delamination, electrochemical delamination, or a combination thereof.

Mechanical delamination methods suitable for the invention are well-known to the skilled person. Examples of a mechanical delamination methods include using polyvinyl alcohol or polymethyl methacrylate films to delaminate the graphene from the layered structure. Example of a mechanical delamination method includes wet transfer, quasi-dry transfer, and dry transfer. A wet transfer method and/or a quasi-dry transfer method preferably uses an etchant to remove the layered structure.

Electrochemical delamination methods (also referred to as electrochemical transfer methods) suitable for the invention are also well-known to the skilled person. An example of an electrochemical delamination method is described in Verguts et al., Graphene delamination using 'electrochemical methods : an ion intercalation effect, Nanoscale, 2018, 10, 5515. A further example of electrochemical delamination is bubble transfer.

### TEST METHODS

The test methods which follow were utilized within the context of the invention. Unless stated otherwise, the measurements were conducted at an ambient temperature of 23 °C, an ambient air pressure of 100 kPa (0.986 atm) and a relative air humidity of 50 %.

### Crystal orientation

The crystal orientation is determined using X-ray diffraction analysis and according to the standard ISO 22278:2020(en). The single crystal structure of a layer (*e.g.,* first layer, further layer) is also determined according to the standard ISO 22278:2020(en).

### Chemical composition of layers

The chemical composition of a layer (*e.g.,* the first layer) is determined using X-ray diffraction analysis and according to the standard ISO 3497:2000. For example, this measurement method is used to determine the wt-% of copper and/or the wt-% of nickel in a first layer thar comprises copper and nickel. X-ray diffraction analysis is suitable for determining the chemical composition of chemical elements that are present in a layer in the amount of 1 wt-% or more.

If the wt-% of a chemical element in a layer is less than 1 wt-%, then X-ray photoelectron spectroscopy is used. The X-ray photoelectron spectroscopy is performed according to the standard ISO 13424:2013(en).

### Thickness of layer

A thickness of a layer is measured using transmission electron microscopy (TEM). The TEM device used for the measurement is calibrated according to ISO 29301:2017.

The number of graphene layers is measured using Raman spectroscopy and according to the standard ISO/TS 21356-1:2021(en).

### Surface roughness

The surface roughness *Rq* (also known as the root mean square average *Rms*) is measured using atomic force microscopy and according to the standard EN ISO 25178-6:2010-01.

### Ratio of thermal expansion coefficients

The ratio of the thermal expansion coefficient of the first layer to a thermal expansion coefficient of the further layer is calculated by dividing the thermal expansion coefficient of the first layer by the thermal expansion coefficient of the further layer. For this calculation, the values of the thermal expansion coefficient, as given using °C, are used.

### Adhesion force

Adhesion force can be measured using atomic force microscopy according to the standard ISO 23729:2022.

### Folds and wrinkles in graphene layer

A graphene layer with a size of 0.5 cm² is provided. A scanning electron microscope (SEM) image is taken of the graphene layer. The surface area of the graphene layer that has folds and wrinkles can be obtained from the SEM image. The wrinkle heights are obtained using atomic force microscopy according to the standard ISO 25178.

### Temperature

The temperature of the cavity is determined using a thermocouple connected to a portable digital temperature calibrator. The portable digital temperature calibrator is the model CL3515R, commercially available from MTI Corporation (USA). The thermocouple is a K type thermocouple with an alloy sheath. The thermocouple has a length of914 mm and a sheath diameter of6 mm. The thermocouple is also commercially available from MTI Corporation (USA). The temperature measurement is taken at a distance of 5 cm from the layered structure.

### Pressure

The pressure is measured using a piezo/Pirani combination gauge with a measurement range between 5 × 10⁻⁴ to 1200 mbar. A suitable measurement gauge is commercially available from Thyracont Vacuum Instruments GmbH (Germany).

The invention is now illustrated by non-limiting examples and exemplifying embodiments.

### FIGURES

### List of figures

The figures serve to exemplify the present invention and should not be viewed as limiting the invention. Furthermore, the figures are not drawn to scale.
Fig. 1: schematic illustration of a cross-sectional cut of a layered structure according to the invention.
Fig. 2: schematic illustration of the steps of a method for producing graphene layer.
Fig. 3: flow diagram showing the steps of a method for producing a layered structure.
Fig. 4: flow diagram showing the steps of a method for producing a graphene layer.
Fig. 5: schematic illustration of the Miller indices used to define the crystal lattice planes.
Fig. 6: schematic illustration of the angle between crystal lattice planes.

### Description of figures

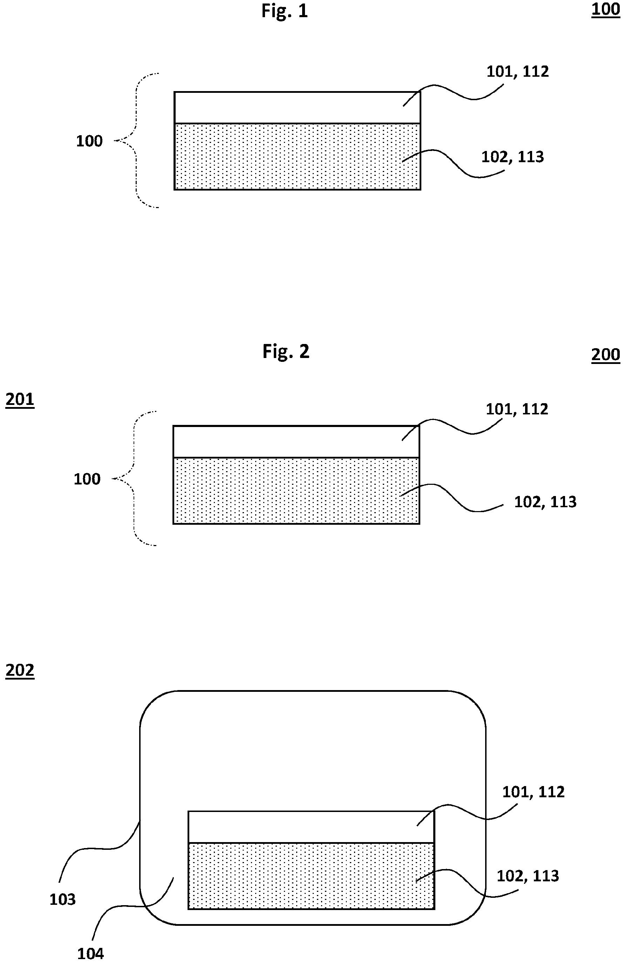

Fig. 1 shows a schematic illustration of a cross-sectional cut of a layered structure (100) according to the invention. The layered structure has a first layer (101) that comprises a first metal and at least one other chemical element. The at least one other element is a further metal. The first metal and further metal are in chemically bound form to form a first alloy. For example, the first metal is copper and the further metal is nickel, thereby forming a copper-nickel alloy. The first layer (101) has a first section (112) that makes up more than 99 vol-% of the first layer (101). The first section (112) has a crystal orientation that lies in a first crystal plane, wherein a first angle between the first crystal plane and the (168)-plane is in the range of -5° to 5°. Preferably, the first crystal plane has a (168) or a (169) orientation. The first section (112) has a single crystal structure.

The layered structure also comprises a further layer (102). The first layer (101) is superimposed in the further layer (102) such that the first layer (101) and the further layer (102) touch. The further layer comprises an oxide, such as magnesium oxide. The further layer (102) also has a further section (113) that makes up more than 99 vol-% of the further layer (102). The further section (113) has a crystal orientation that lies in a further crystal plane, wherein a further angle between the further crystal plane and the (168)-plane is in the range of-5° to 5°. Preferably, the further crystal plane has a (168) or a (169) orientation. The further section (113) has a single crystal structure.

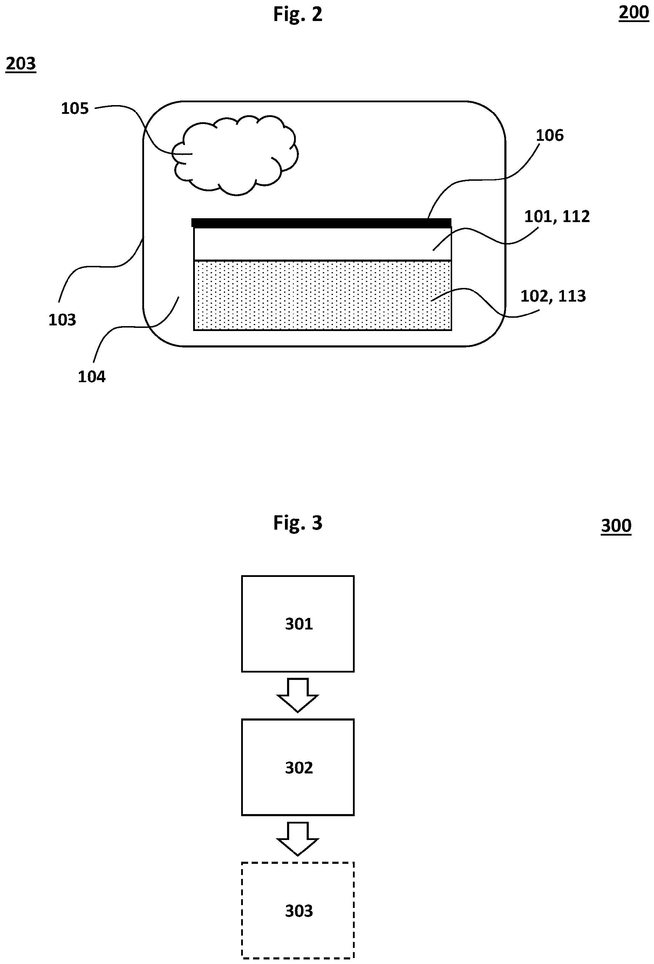

Fig. 2 shows a schematic illustration of the steps of a method (200) for producing a graphene layer. In step 201, a layered structure according to Fig. 1 is provided. In step 202, the layered structure (100) is placed in a cavity (104) of a quartz tube furnace (103). In step 203, a carbon precursor (105), in the form of methane gas, is injected into the cavity (104) and the cavity (104) is heated to a temperature of 730 °C. A single graphene layer (106) is obtained, wherein the graphene layer (106) is superimposed on the first layer (101) of the layered structure (100). The graphene layer (106) touches the first layer (101).

Fig. 3 shows a flow diagram of the steps of a method for producing a layered structure. In Step 301, a further layer is provided. In Step 302, a first layer is deposited on the further layer to obtain the layered structure (*i.e.,* the first layer is superimposed on the further layer). The first layer is deposited using physical vapour deposition and via molecular-beam epitaxy. The first layer is deposited such that the first layer and the further layer touch. In optional step 303, the layered structure is heat treated at a temperature of 500 °C.

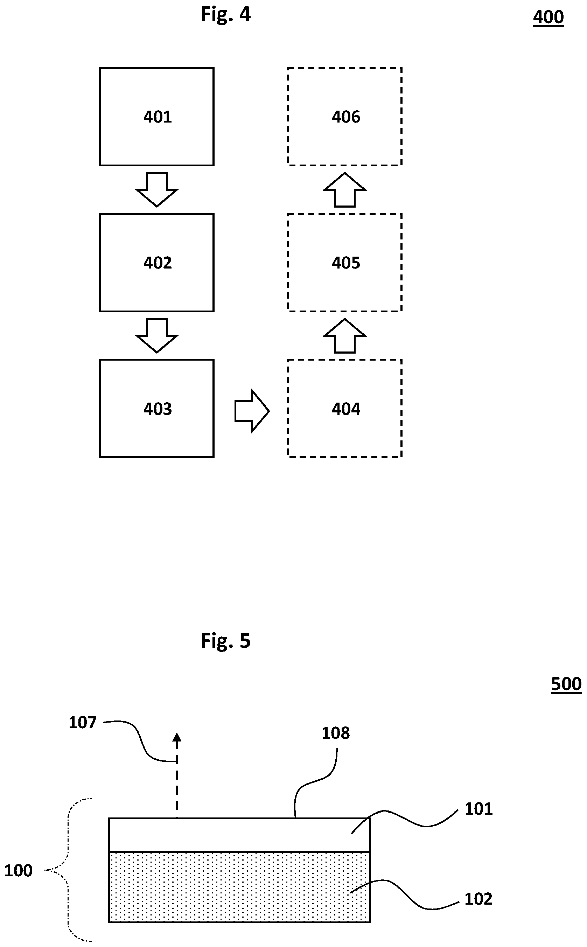

Fig. 4 shows a flow diagram of the steps of a method for producing a graphene layer. In Step 401, the layered structure obtained from the method in Fig. 3 is provided. In Step 402, the layered structure is placed in a cavity. In Step 403, the layered structure is heated in the presence of a gaseous carbon precursor in the cavity, thereby obtaining a graphene layer that is superimposed on the first layer of the layered structure. In optional Step 404, the layered structure, comprising the graphene layer, is removed from the cavity. The layered structure is subjected to an intercalation step. In optional Step 405, the graphene layer is removed from the layered structure using an electrochemical delamination method. In optional Step 406, the layered structure is re-used to deposit a further graphene layer on the layered structure (*i.e.,* Steps 402 and 403 are repeated).

Fig. 5 is a schematic illustration of the Miller indices used to define the crystal lattice planes. Fig. 5 shows the layered structure (100) of Fig. 1. The Miller index ℓ (107) is arranged perpendicular to a surface (108) of the first layer (101).

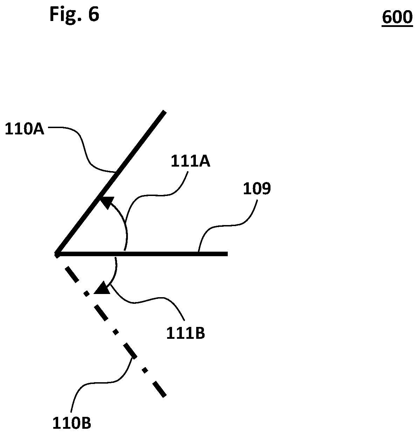

Fig. 6 is a schematic illustration of how the angle between crystal lattice planes is defined. Fig. 6 shows a (168)-plane (109) and a first crystal plane (110A). A first angle (111A) between the crystal lattice planes (109) and (110) is defined as the dihedral angle between said crystal lattice planes. The first angle (111) is measured starting from the (168)-plane (109) and moving to the first crystal plane (110). If the first angle is measured counterclockwise, then the first angle is positive. This is illustrated by the first crystal plane (110A) and the first angle (111A). If the first angle is measured clockwise, then the first angle is negative. This is illustrated by the first crystal plane (110B) and the first angle (111B).

The second angle between the second crystal plane and the (111)-plane is measured in the same manner as described in Fig. 6. Here the second angle is measured starting from the (11 1)-plane and moving to the second crystal plane. A further angle between a further crystal plane and, *e.g.,* the (168)-plane is measured in the same manner as described in Fig. 6. Here the further angle is measured starting from the (168)-plane and moving to the further crystal plane. A third angle between a third crystal plane and, *e.g.,* the (0001)-plane is measured in the same manner as described in Fig. 6. Here the third angle is measured starting from the (0001)-plane and moving to the third crystal plane. An even-further angle between the first crystal plane and the further crystal plane is measured in the same manner as described in Fig. 6. Here the even-further angle is measured starting from the first crystal plane and moving to the further crystal plane. This also applies for measuring an angle between the second crystal plane and the third crystal plane.

### EXAMPLES

The invention is illustrated further by way of examples. The invention is not restricted to the examples. The set-up described below applies to all the examples.

### Set-up

Unless specified otherwise, the below set-up applies to all examples.

A further layer of magnesium oxide is provided. A first layer is deposited onto the further layer using physical vapour deposition to obtain a layered structure. The first layer and the further layer touch each other. The first layer has a thickness of 0.5 µm . Both a first section of the first layer and a further section of the further layer have a single crystal structure. The first section makes up at least 99 vol-% of the first layer. The further section makes up at least 99 vol-% of the further layer.

The layered structure is placed in a cavity of a quartz-tube furnace. 5 sccm H₂ and 300 sccm Ar are first allowed to flow through the cavity for 30 min at a pressure of 130 mbar (sccm is standard cubic centimetres per minute). After 30 minutes, 20 sccm of 0.3% ethylene, diluted in Ar, is allowed to flow through the cavity for 1 hour, thereby leading to a graphene layer being obtained on the layered structure. Once obtained, the layered structure with the graphene is rapidly cooled down at the same gas flow and pressure.

Once cooled, the layered structure is removed from the cavity. The graphene layer is removed from the layered structure using a mechanical delamination method with polyvinyl alcohol (PVA). The PVA used is commercially available from Sigma Aldrich. 7 g polyvinyl alcohol (8000 - 10000 MW, 80% hydrolysed) and 3 g PVA (85000 - 124000 MW, 87-89 % hydrolysed) is mixed with 40 mL deionised water and stirred at 80 °C until the PVA is fully dissolved. 0.1 ml cm⁻² of the dissolved PVA is placed on a removable support and dried at room temperature to obtain a PVA film. The PVA film is then placed onto the graphene layer (that is superimposed on the layered structure), and heated to 120 °C. The PVA, graphene layer, and layered structure are then allowed to cool to 23 °C, with the PVA and graphene layer subsequently removed from the layered structure. The PVA can be removed from the graphene layer by placing the PVA and graphene layer in 80 °C deionised water 30 hours.

Unless specified otherwise, a "+" indicates an increase in the desired technical effect, whereas a "-" indicates a poorer technical effect.

### Example 1

In Examples 1.1 to 1.4, both the first layer and the further layer have a single crystal structure. For the deposition of the graphene layer, a temperature in the cavity of the quartz-tube furnace is shown in Table 1.

Apart from the different growth temperatures, the differences between Examples 1.1 to 1.4 are the following:
- Example 1.1: the first layer has a crystal orientation of (111) and is made from copper. The further layer also has a crystal orientation of (111).
- Example 1.2: the first layer has a crystal orientation of(1 11) and is made from a copper-nickel alloy (75 wt-% Cu and 25 wt-% Ni, based on the weight of the first layer). The further layer also has a crystal orientation of (111).
- Example 1.3: the first layer has a crystal orientation of (168) and is made from copper. The further layer also has a crystal orientation of (168).
- Example 1.4: the first layer has a crystal orientation of (168) and is made from a copper-nickel alloy (75 wt-% Cu and 25 wt-% Ni, based on the weight of the first layer). The further layer also has a crystal orientation of (168).

Table 1 shows a comparison of the results obtained from Examples 1.1 to 1.4. In Table 1, the scale used is "-----", "----", "---", "--", "-", "+", "++", "+++", "++++", "+++++".

**Table 1**

| **Example** | **1.1** | **1.2** | **1.3** | **1.4** |
|---|---|---|---|---|
| | | | | |
| Crystal orientation: first and further layers | (111) | (111) | (168) | (168) |
| First layer | Cu | Cu-Ni | Cu | Cu-Ni |
| Further layer | MgO | MgO | MgO | MgO |
| Growth temperature [°C] | 1030 | 730 | 1030 | 730 |
| | | | | |

| **Technical effect** | | | | |
|---|---|---|---|---|
| Adhesion force | Strong | Strong | Weak | Weak |
| Effect of delamination | Large number of holes and tears in delaminated graphene | Large number of holes and tears in delaminated graphene | Small number of holes and tears in delaminated graphene | Very small number of holes and tears in delaminated graphene |
| Reuse of layered structure | Not possible, graphene stuck to layered structure | Not possible, graphene stuck to layered structure | Possible for a limited number of times | Possible for a very large number of times |
| Presence of wrinkles | Yes | No | Yes | No |
| Quality of graphene | + | ++ | ++ | +++ |
| Applications of graphene layer obtained | Very limited | Very limited | Large number of applications | Very large number of applications |

In Table 1, the growth temperature is chosen in order to increase the technical effects for that specific example. For example, growing a graphene layer at 730 °C in Example 1.1 leads to graphene with significantly poorer quality compared to a graphene layer grown using a temperature of 1030 °C.

The technical effects in Table 1 are as follows:
- Adhesion force: the adhesion force between the graphene layer and the layered structure.
   It is desired to have a smaller (weaker) adhesion force.
- Effect of delamination: damage caused to the graphene layer when delaminating the graphene layer from the layered structure. It is desired to reduce the damage.
- Reuse of layered structure: once the graphene layer has been removed from the layered structure, whether the layered structure can be reused to grow further graphene layers. It is desired to reuse the layered structure.
- Presence of wrinkles: whether wrinkles are present in the graphene layer that is obtained.
   It is desired to reduce the number of wrinkles, preferably to have no wrinkles.
- Quality of graphene: the quality of the graphene layer obtained from the examples. For example, the number of holes, wrinkles and grain boundaries in the graphene layer that is grown. It is desired to improve the quality of the graphene grown by, *e.g.,* reducing the number of holes, wrinkles, and grain boundaries. For example, "+++" indicates better quality than "+".
- Applications of graphene layer obtained: the number of electrical components in which the obtained graphene layer can be used. A larger number of electrical components is desired.

### Example 2

For Examples 2.1 to 2.4, the first layer has a crystal orientation of (168) and is made from a copper-nickel alloy (75 wt-% Cu and 25 wt-% Ni, based on the weight of the first layer). The further layer also has a crystal orientation of (168). Furthermore, both the first layer and the further layer have a single crystal structure.

For Examples 2.1 to 2.4, different temperatures are used for the cavity of the quartz-tube furnace when depositing the graphene layer. The different temperatures are shown in Table 2. In example 2, the first layer has a crystal orientation of (168).

Table 2 shows a comparison of the results obtained from Examples 2.1 to 2.4. In Table 2, the scale used is "-----", "----", "---", "--", "-", "+", "++", "+++", "++++", "+++++".

**Table 2**

| **Example** | **2.1** | **2.2** | **2.3** | **2.4** |
|---|---|---|---|---|
| | | | | |
| Temperature [°C] | 550 | 730 | 820 | 950 |
| | | | | |

| **Technical effect** | | | | |
|---|---|---|---|---|
| Wrinkle formation | No | No | Yes | Yes |
| Defect formation | Yes | No | No | No |
| Growth rate | + | ++ | +++ | ++++ |
| Dewetting rate | +++ | + | - | --- |
| Applications of graphene layer obtained | -- | ++++ | ++ | -- |

The technical effects in Table 2 are as follows:
- Wrinkle formation: whether the graphene layer that is grown has wrinkles. It is desired that the number of wrinkles is reduced. It is more desired that the graphene layer has no wrinkles.
- Defect formation: the number of defects per unit area in the graphene layer. Defects include one or more atoms missing in crystal lattice of the graphene layer. It is desired that the number of defects is reduced. It is more desired that the graphene layer has no defects.
- Growth rate: the rate at which the graphene layer is grown in the furnace. It is desired to increase the growth rate. An increased growth rate indicate that the time required to grow the graphene layer in the furnace is reduced. For example, "++" indicates a faster growth rate than "+". While an increased growth rate is generally desired, if the growth rate is too fast, this leads to defects in the graphene layer. This is observed in Example 5.6. The growth rates shown in Table 2 do not negatively affect the quality of the graphene layers.
- Dewetting rate: the rate at which the Cu-Ni first layer dewets, *i.e.,* the transformation of the first layer into sets of droplets. It is desired to decrease the dewetting rate. For example, "-" indicates a larger dewetting rate than "+"
- Applications of graphene layer obtained: the number of electrical components in which the obtained graphene layer can be used. It is desired to increase the number of applications. For example, "+" indicates a larger number of applications than "-".

Results that are similar to those of Example 2.1 are found when the temperature is 650 °C or less. Results that are similar to those of Example 2.2 are found when the temperature is in the range from > 650 °C to 750 °C. Results that are similar to those of Example 2.3 are found when the temperature is in the range from > 750 °C to 900 °C. Results that are similar to those of Example 2.4 are found when the temperature is above 900 °C.

### Example 3

For Examples 3.1 and 3.2, the first layer has a crystal orientation of (168) and is made from a copper-nickel alloy (75 wt-% Cu and 25 wt-% Ni, based on the weight of the first layer). The further layer also has a crystal orientation of (168). For the growing of the graphene, a temperature in the cavity of the quartz-tube furnace is 730 °C.

The differences between Examples 3.1 and 3.2, are the following:
- Example 3.1: the first layer and the further layer do not have a single crystal structure.
- Example 3.2: both the first layer and the further layer have a single crystal structure.

Table 3 shows a comparison of the results obtained from Examples 3.1 and 3.2. In Table 3, the scale is "-----", "----", "---", "--", "-", "+", "++", "+++", "++++", "+++++".

**Table 3**

| **Example** | **3.1** | **3.2** |
|---|---|---|
| | | |
| Single crystal structure | No | Yes |
| | | |

| **Technical effect** | | |
|---|---|---|
| Residual charge carrier fluctuations (n*) | Higher | Lower |
| Electron mobility | - | ++ |
| Applications of graphene layer obtained | + | ++ |

The technical effects in Table 3 are the same as the technical effects of Table 2, with the following additional technical effect:
- Residual charge carrier fluctuations (n^{∗}): n^{∗} is determined by intrinsic defects, the doping, and the localised charge state of a graphene layer. n^{∗} is an indication of scattering in the graphene layer. A lower n^{∗} is desired.
- Electron mobility: a characterisation of how quickly an electron can move through the graphene layer. A larger electron mobility is desired. For example, "+" indicates a larger electron mobility than "-".

### Example 4

In Examples 4.1 to 4.9, the temperature in the cavity of the quartz-tube furnace is varied, as well as the carbon source used to obtain the graphene layer (the carbon source is in the form of gas that is allowed to flow through the cavity of the furnace). Furthermore, for Examples 4.1 to 4.9, the first layer has a crystal orientation of (168) and is made from a copper-nickel alloy (75 wt-% Cu and 25 wt-% Ni, based on the weight of the first layer).

Table 4 shows a comparison of the results obtained from Examples 4.1 to 4.9. In Table 4, the scale is "-----", "----", "---", "-", "-", "+", "++", "+++", "++++", "+++++".

**Table 4**

| **Ex.** | **4.1** | **4.2** | **4.3** | **4.4** | **4.5** | **4.6** | **4.7** | **4.8** | **4.9** |
|---|---|---|---|---|---|---|---|---|---|
| | | | | | | | | | |
| Carbon source | C₂H₂ | C₂H₂ | C₂H₂ | C₂H₄ | C₂H₄ | C₂H₄ | CH₄ | CH₄ | CH₄ |
| Growth Temp [°C] | 550 | 730 | 930 | 550 | 730 | 930 | 550 | 730 | 930 |
| Applies to [°C] | 300 - 600 | 600-900 | 900 - 1200 | 300 - 600 | 600 - 900 | 900 - 1200 | 300 - 600 | 600 - 900 | 900 - 1200 |
| | | | | | | | | | |

| **Technical effect** | | | | | | | | | |
|---|---|---|---|---|---|---|---|---|---|
| Growth rate | +++ | - | --- | --- | +++ | + | --- | + | +++ |
| Defect formation | + | ++ | +++ | +++ | -- | --- | +++ | + | -- |

In Table 4, temperatures of 800 °C and higher lead to the formation of wrinkles in the graphene layer.

In Table 4 the carbon sources are acetylene (C₂H₂), ethylene (C₂H₄), and methane (CH₄). Table 4 also shows the temperature ranges for which the results of Examples 4.1 to 4.9 apply to, *i.e.,* similar technical effects are obtained when the temperature is selected that falls within the indicated range. For example, similar results to those of Experiment 4.1 are obtained when acetylene and a temperature that falls within the range of 300 to 600 °C is used.

The technical effects in Table 4 are as follows:
- Defect formation: the number of defects per unit area in the graphene layer. Defects include one or more atoms missing in crystal lattice of the graphene layer. It is desired that the number of defects is reduced. It is more desired that the graphene layer has no defects. For example, "++" indicates less defects than "+".
- Growth rate: the rate at which the graphene layer can be grown in the furnace. It is desired to increase the growth rate. An increased growth rate indicate that the time required to grow the graphene layer in the furnace is reduced. For example, "++" indicates a faster growth rate than "+". While an increased growth rate is generally desired, if the growth rate is too fast, this leads to defects in the graphene layer. This is observed in Example 5.6. The growth rates shown in Table 4 do not negatively affect the quality of the graphene layers.

### Example 5

In Examples 5.1 to 5.6, the first layer is made from Cu and Ni, and has a crystal orientation of (168). Furthermore, in Examples 5.1 to 5.6 the wt % of Cu and Ni in the first layer is varied as shown in Table 5.

Table 5 shows a comparison of the results obtained from Examples 5.1 to 5.6. In Table 5, the scale used is "-----", "----", "---", "--", "-", "+", "++", "+++", "++++", "+++++".

**Table 5**

| **Example** | **5.1** | **5.2** | **5.3** | **5.4** | **5.5** | **5.6** |
|---|---|---|---|---|---|---|
| | | | | | | |
| Cu [wt %] | 100 | 99 | 95 | 85 | 75 | 50 |
| Ni [wt %] | 0 | 1 | 5 | 15 | 25 | 50 |
| | | | | | | |

| **Technical effect** | | | | | | |
|---|---|---|---|---|---|---|
| Approx. melting Temp [°C] | 1080 | 1085 | 1125 | 1200 | 1250 | 1325 |
| C solubility at 750 °C | --- | -- | + | ++ | +++ | ++++ |
| Growth rate at 1030 °C | + | + | ++ | +++ | ++++ | +++++ |
| Ideal growth temp range [°C] | 1030 - 1060 | 1000 - 1060 | 900 - 1050 | 700 - 900 | 600 - 800 | 500 - 700 |
| Ideal growth carbon source | Methane | Methane | Methane | Ethylene | Ethylene | Ethylene |
| Growth rate using ideal growth temp range | + | + | ++ | +++ | ++ | ++++ |

The technical effects in Table 5 are as follows:
- Approx melting temp: the temperature at which the first layer melts. A higher melting temperature is desired.
- C solubility at 750 °C: the solubility of C in the Ni present in the first layer. It is desired to increase the solubility. For example, "+" indicates a larger solubility than "-".
- Growth rate at 1030 °C: the rate at which the graphene layer can be grown in the furnace at a temperature of 1030 °C. It is desired to increase the growth rate. An increased growth rate indicate that the time required to grow the graphene layer in the furnace is reduced. For example, "++" indicates a faster growth rate than "+".

- Ideal growth temp range: the temperature range that leads to a maximum growth rate for the graphene layer, when using a first layer as indicated in Table 5. A smaller ideal growth temperature is preferred.
- Ideal growth carbon: the carbon source, in gas form, that leads to a maximum growth rate for the graphene layer, when using a first layer as indicated in Table 5.
- Growth rate using ideal growth temp range: the rate at which the graphene layer can be grown in the furnace when the temperature in the cavity falls within the ideal growth temperature range, as indicated in Table 5. It is desired to increase the growth rate. An increased growth rate indicate that the time required to grow the graphene layer in the furnace is reduced. For example, "++" indicates a faster growth rate than "+".

The graphene obtained from Example 5.6 has many sections that has two overlapping graphene layers. This leads to very low-quality graphene. Furthermore, while an increased growth rate is generally desired, if the growth rate is too fast, this leads to defects in the graphene layer. This is observed in Example 5.6. The growth rates shown in Examples 5.1 to 5.5 do not negatively affect the quality of the graphene layers.

### Example 6

In Examples 6.1 and 6.2 graphene layers are obtained according to Example 1.1. In Examples 6.3 and 6.4 graphene layers are obtained according to Example 1.3. In Examples 6.5 to 6.6 graphene layers are obtained according to Example 1.4. The graphene layers of Examples 6.1 to 6.6 are removed (delaminated) from the layered structure using the dry transfer methods shown in Table 6.1 below. The graphene layers are either removed using a polymer film or a layer of hexagonal boron nitride (hBN).

Table 6.1 shows a comparison of the results obtained from Examples 6.1 to 6.6. In Table 6.1, the scale used is "-----", "----", "---", "--", "-", "+", "++", "+++", "++++", "+++++".

**Table 6.1**

| **Example** | **6.1** | **6.2** | **6.3** | **6.4** | **6.5** | **6.6** |
|---|---|---|---|---|---|---|
| | | | | | | |
| Graphene obtained according to | Example 1.1 | Example 1.1 | Example 1.3 | Example 1.3 | Example 1.4 | Example 1.4 |
| Crystal orientation of first layer | (111) | (111) | (168) | (168) | (168) | (168) |
| First layer | Cu | Cu | Cu | Cu | Cu-Ni | Cu-Ni |
| Transfer Method | Dry (with polymer) | Dry (with hBN) | Dry (with polymer) | Dry (with hBN) | Dry (with polymer) | Dry (with hBN) |
| | | | | | | |

| **Technical effect** | | | | | | |
|---|---|---|---|---|---|---|
| Catalyst reusability | ++++ | ++++ | ++++ | ++++ | ++++ | ++++ |
| Intercalation speed | --- | --- | ++ | ++ | ++ | ++ |
| Transfer speed | ++ | + | ++ | + | ++ | + |
| Number of defects | - | +++ | + | +++ | ++ | ++++ |
| Introduced roughness | - | + | - | + | + | ++ |
| Introduced doping | - | + | - | + | - | + |
| Raman 2D FWHM [1/cm] | 20-30 | 14-22 | 20-30 | 14-22 | 20-30 | 14-22 |

The technical effects in Table 6.1 are as follows:
- Catalyst reusability: how often the catalyst used in the transfer method can be used. It is desired that the catalyst can be reused more often. For example, "+" indicates a catalyst that can be re-used more times than "-".
- Intercalation speed: the speed at which an intercalation layer forms between the graphene layer and the first layer of the layered structure. It is desired to increase the intercalation speed. For example, "++" indicates a larger intercalation speed than "-".
- Transfer speed: the speed at which the graphene layer can be transferred from the layered structure to a substrate or another layer of, *e.g.,* an opto-electronic device. It is desired to increase the transfer speed. For example, "+++" indicates a faster transfer speed than _{"+"}
- Number of defects: the number of defects per unit area that are introduced into the graphene layer as a result of the transfer method. It is desired to reduce the number of defects. Defects include holes and tears in the graphene layer. For example, "+++" indicates less defects than "---".
- Introduced roughness: the surface roughness *Rq* of the graphene layer that results from the transfer method. It is desired to reduce the introduced surface roughness. For example, "++++" is better than "-".
- Introduced doping: the doping that is introduced into the graphene layer as a result of the transfer method. It is desired to reduce the introduced doping. For example, "++++" is better than "-" .
- Raman 2D FWHM: the full width at half maximum of the measurement obtained using Raman spectroscopy of the graphene layer. It is desired to reduce the Raman 2D FWHM value.

Table 6.2 shows a comparison of different methods for transferring a graphene layer from the layered structure. For Examples 6.5 to 6.9 in Table 6.2, the graphene layer was obtained according to Example 1.4. Examples 6.5 and 6.6 in Table 6.1 are repeated in Table 6.2 to aid comparison of the results.

Table 6.2 shows a comparison of the results obtained from Examples 6.5 to 6.9. In Table 6.2, the scale used is "-----", "----", "---", "-", "-", "+", "++", "+++", "++++", "+++++".

**Table 6.2**

| **Example** | **6.5** | **6.6** | **6.7** | **6.8** | **6.9** |
|---|---|---|---|---|---|
| | | | | | |
| Transfer Method | Dry (with polymer) | Dry (with hBN) | Electrochemical | Wet | Quasi-dry |
| | | | | | |

| **Technical effect** | | | | | |
|---|---|---|---|---|---|
| Catalyst reusability | ++++ | ++++ | + | --- | --- |
| Intercalation speed | ++ | ++ | ++ | N/A | N/A |
| Transfer speed | ++ | + | +++ | +++ | ++ |
| Number of defects | - | +++ | -- | --- | -- |
| Introduced roughness | - | + | ---- | ---- | -- |
| Introduced doping | - | + | -- | ---- | --- |
| Raman 2D FWHM [1/cm] | 20-30 | 14-22 | > 30 | 30-40 | 27-35 |

From Table 6.2 it follows that using a dry transfer method provides significant technical advantages over the other transfer methods shown in Table 6.2. The technical effects in Table 6.2 are the same as those of Table 6.1.

### Example 7

Examples 7.1 to 7.3 are the same as Example 1.4, with the difference that the thickness of the Cu-Ni layer (the first layer) is varied as shown in Table 7.

Table 7 shows a comparison of the results obtained from Examples 7.1 to 7.3.

**Table 7**

| **Example** | **7.1** | **7.2** | **7.3** |
|---|---|---|---|
| | | | |
| Cu-Ni thickness [µm] | < 0.5 | 0.5-1 | 1-3 |
| | | | |

| **Technical effect** | | | |
|---|---|---|---|
| Layer roughness [nm] | < 0.1 | 0.1-0.3 | > 0.3 |
| Dewetting rate [pts/µm] | > 50 | 0- 15 | 0 |

The technical effects in Table 7 is as follows:
- Layer roughness: the surface roughness *Rq* of the first layer. It is desired to have a lower surface roughness.
- Dewetting rate: the rate at which the Cu-Ni first layer dewets, *i.e*., the transformation of the first layer into sets of droplets. It is desired to decrease the dewetting rate.

### Example 8

Table 8 shows the requirements of devices that use at least one graphene layer. When a graphene layer obtained according to the invention (*e.g.*, Example 1.4) is used in these devices, this leads to an improved meeting of the requirements, compared to using a graphene layer that has not been obtained according to the invention.

**Table 8**

| **Example** | **8.1** | **8.2** | **8.3** |
|---|---|---|---|
| | | | |
| Device | Photodetector | Modulator | Magnetic sensor |
| | | | |

| **Requirement** | | | |
|---|---|---|---|
| Electron mobility | Low to moderate mobility depending on application | Higher mobility for high switching speeds | Highest mobility required to decrease scattering time |
| Doping | Much higher responsivity with less doping | Uniform doping variations required for consistent optical modulation amplitude | Not directly impacting performance |
| Defects | Decreases responsivity | Decreases performance. (Decreases optical modulation amplitude for drive voltage) | Greatly decreases sensitivity |

### REFERENCE LIST

- 100: Layered structure
- 101: First layer
- 102: Further layer
- 103: Quarts tube furnace
- 104: Cavity
- 105: Carbon precursor
- 106: Graphene layer
- 107: Miller index ℓ
- 108: Surface of first layer
- 109: (168)-plane
- 110: First crystal plane
- 111: First angle
- 112: First section
- 113: Further section

## Claims

1. A layered structure (100) comprising
a. a first layer (101), wherein
i. the first layer (101) comprises a first metal and at least one other chemical element,
ii. the first layer (101) has a first section (112), wherein the first section (112) has a crystal orientation that lies in a first crystal plane;
iii. the Miller index ℓ, used to define the crystal lattice planes, is arranged perpendicular to a surface (108) of the first layer (101);
wherein
a first angle (111) between the first crystal plane and the (168)-plane is in the range of -18° to 18°.

2. The layered structure according to claim 1, wherein the first layer comprises a first alloy, and wherein the first alloy comprises at least one or all of the following: silicon, sulphur, iron, cobalt, nickel, copper, germanium, molybdenum, ruthenium, rhodium, palladium, tin, tungsten, rhenium, iridium, platinum, gold, a combination of at least two thereof.

3. The layered structure according to any of the preceding claims, wherein the first layer comprises a first alloy, and wherein the first alloy comprises at least one or all of the following:
a. in the range of 60 wt-% to 99 wt-% copper, where the wt-% are based on a total weight of the first layer;
b. in the range of 1 wt-% to 40 wt-% nickel, where the wt-% are based on a total weight of the first layer.

4. The layered structure according to any of the preceding claims, wherein the first layer has a thickness in the range of 0.01 µm to 30 µm.

5. The layered structure according to any of the preceding claims, wherein at least 50 vol-% of the first layer has a single crystal structure.

6. The layered structure according to any of the preceding claims, wherein the first layer has a surface roughness *Rq* that is in the range of 0.05 nm to 1 nm.

7. The layered structure according to any of the preceding claims, wherein the layered structure further comprises a further layer, and wherein
a. the first layer is superimposed on the further layer; and
b. the further layer comprises at least one or all of the following: at least one further alloy, at least one oxide, at least one nitride, at least one carbide, at least one element from group III of the periodic table, at least one element from group IV of the periodic table, at least one element from group V of the periodic table, a combination of two or more thereof.

8. A method for producing the layered structure according to any of the preceding claims, comprising the steps of:
a. optionally, providing a further layer (102);
b. depositing the first layer (101) to obtain the layered structure.

9. A method for producing at least one graphene layer, comprising the steps of
a. providing a layered structure (100) according to any of the claims 1 to 7, or a layered structure obtainable according to claim 8;
b. placing the layered structure in a cavity (104);
c. heating the layered structure in the presence of a gaseous carbon precursor (105) in the cavity (104), thereby obtaining the at least one graphene layer (106), and wherein the at least one graphene layer (106) is superimposed on the layered structure (100),
wherein
a temperature in the cavity is in the range of 300 °C to 2000 °C.

10. A layered structure according to any of the claims 1 to 7, or a layered structure obtainable according to claim 8, further comprising at least one graphene layer.

11. A method, comprising the steps of
a. providing a layered structure according to the preceding claim 10;
b. at least partially removing the at least one graphene layer.

12. A graphene layer obtainable by a method according to any of the claims 9 or 11.

13. An electrical component comprising a graphene layer according to any of the claims 10 to 12.

14. Use of a layered structure according to any of the claims 1 to 7, or a layered structure obtainable according to claim 8, for producing at least one graphene layer.

15. Use of a graphene layer according to any of the claims 10 to 12 in an electrical component.
